# EUROPEAN PATENT SPECIFICATION

(11) **EP 1 685 269 B1**
(45) Date of publication and mention of the grant of the patent: **15.07.2009**
(21) Application number: 04799409.0
(22) Date of filing: 09.11.2004
(51) Int. Cl.: C23C 14/14, C23C 14/58, C23C 22/64, C23C 22/54

(54) **PROCESS FOR MANUFACTURING DEVICES WHICH REQUIRE A NON EVAPORABLE GETTER MATERIAL FOR THEIR WORKING**
VERFAHREN ZUR FERTIGUNG VON VORRICHTUNGEN, DIE ZUM ARBEITEN EIN NICHT VERDAMPFBARES GETTERMATERIAL BENÖTIGEN
PROCEDE POUR PRODUIRE DES DISPOSITIFS QUI NECESSITENT UN MATERIAU GETTER NON EVAPORABLE POUR FONCTIONNER

(30) Priority: 14.11.2003 IT MI20032209
(43) Date of publication of application: 02.08.2006
(73) Proprietor: SAES GETTERS S.p.A., 20020 Lainate (Milano) (IT)
(72) Inventor: MORAJA, Marco, I-20161 Milano (IT); AMIOTTI, Marco, I-20010 Cornaredo (IT); DRAGONI, Costanza, I-06125 Perugia PG (IT); PALLADINO, Massimo, I-20020 Lainate (IT)
(74) Representative: Adorno, Silvano
(86) International application number: PCT/IT2004/000615
(87) International publication number: WO 2005/047558

(56) References cited:
- US-A1- 2003 138 656
- YUFENG JIN ET AL: "An investigation on NEG thick film for vacuum packaging of MEMS" PROCEEDINGS OF THE SPIE - THE INTERNATIONAL SOCIETY FOR OPTICAL ENGINEERING SPIE-INT. SOC. OPT. ENG USA, vol. 4980, 27 January 2003 (2003-01-27), - 29 January 2003 (2003-01-29) pages 275-280, XP002341635 ISSN: 0277-786X
- PATENT ABSTRACTS OF JAPAN vol. 1996, no. 12, 26 December 1996 (1996-12-26) & JP 08 210251 A (TOSHIBA CORP), 20 August 1996 (1996-08-20)

## Description

The present invention relates to a process for manufacturing devices which require a non evaporable getter material for their working. The process is particularly suitable for being used in the processes for the manufacture of miniaturized devices.

Non evaporable getter materials, also known as NEG, are capable of reversibly sorbing hydrogen and irreversibly sorbing gases such as oxygen, water, carbon oxides and, in some cases, nitrogen.

The main NEG materials are transition metals such as titanium, zirconium, vanadium, niobium, hafnium and tantalum, or alloys thereof (and in particular titanium and zirconium) with one or more elements selected among the transition metals, Rare Earths and aluminum.

A first use of these materials is for keeping vacuum. The maintenance of vacuum is required in very different applications, as for example in particle accelerators, in X-rays generating tubes, in the flat displays of the field-emission type and in the evacuated jackets for thermal insulation, such as in thermal vessels (thermos), in Dewar bottles or in the pipes for oil extraction and transport.

NEG materials can be also employed to remove the above-mentioned gases when traces thereof are present in other gases, generally noble gases. An example is the use in lamps, particularly fluorescent ones which are filled with noble gases at pressures of some tens of nibar, wherein the NEG material has the function of removing traces of oxygen, water, hydrogen and other gases to keep a suitable atmosphere for the operation of the lamp; another example of removal of traces of the above-mentioned gases by other gases is the purification of inert gases, particularly for applications in the microelectronic industry.

Another emerging application is the use of NEG materials in miniaturized mechanical, electromechanical or optical devices. Since these devices are industrially important, and since the process of the invention is particularly suitable in the manufacturing processes of the same, in the following description reference will be particularly made to these devices and processes, but it is to be intended that the present process has general applicability in each application wherein a NEG material is used.

The miniaturized mechanical or electromechanical devices are generally known in the field with the English definition "Microelectromechanical Systems", or with the abbreviation MEMS, while the miniaturized devices of optical type are known with the abbreviation MODEMS; for the sake of simplicity, however, the definition MEMS will be used in the present text also with reference to MOEMS. MEMS generally comprise an active device (the miniaturized mechanical, ectromechanical or optical part) and ancillary parts, enclosed in a sealed cavity; electrical feedthroughs assure the electrical supply to the device and the transmission of the signals from this toward the outside.

The last generation MEMS are manufactured through technologies derived from the semiconductors industry, which comprise generally depositions on a support of layers of a desired material and selective and localized chemical attacks to remove only predefined parts of a deposited layer or of the support, so as to obtain miniaturized structures and geometries which would not be obtainable through traditional mechanics. Among the main types of MEMS, already used or in development at present, it is possible to mention microaccelerometers, an example of which is disclosed in the patent US 5,952,572, used for example in the motor-car field to perceive collisions and thus to activate the air bag of the vehicle; miniaturized mirrors, such as those disclosed in the patent US 5,155,778, used in the telecommunication systems in optical fiber; the arrays of miniaturized mirrors, as disclosed for example in the patent US 6,469,821, used in the formation of images; or microbolometers, that is, miniaturized detectors of infrared radiation, an example of which is disclosed in the patent US 6,252,229.

Several ways of manufacturing MEMS have been proposed, but the most common ones comprise the use of at least two planar supports made of glass or quartz, ceramic material (e.g. silicon carbide) or semiconductor (silicon is preferred), whereon the different active and passive components of the MEMS are constructed. Commonly, upon one of the two supports (generally made of silicon) the active parts are constructed, for example the movable parts of a micromechanical device, while a second support (which may be made up of glass or quartz, ceramic or semiconductor material) has essentially the function of closing the finished device; the electrical feedthroughs for transferring signals between the inside and the outside of the MEMS may indifferently be obtained on any of the two planar supports.

Once all the components necessary for the operation of the MEMS have been obtained on the two supports, said supports are fixed to each other, by welding them along a line which encloses the components of the device. The miniaturized device is thus sealed in a closed space and is mechanically and chemically protected from the outside. Numerous techniques, collectively known with the definition "bonding", may be used for the welding. A first possibility is the welding, simple or by pressure ("pressure bonding"), wherein between the two supports it is interposed a malleable metal such as indium, lead or gold, and these are then melted and caused to solidify in the case of the simple welding, or pressed between the substrates in the case of pressure bonding: this technique, however, leads to weldings not completely reliable from the mechanical resistance standpoint. Another type of bonding is the anodic bonding (used especially in the case in which one of the two supports is made up of glass or quartz and the other of silicon), wherein between the two parts, kept at a temperature in the range from 300 to 500 °C, is applied a potential difference of about 1000 V; in these conditions, there is a migration of positive ions from the support kept at the more positive potential (for example, sodium ions from the glass) toward the support kept at the more negative potential, and of negative ions (for example, oxygen from silicon) in the opposite direction; this migration of material between the two supports gives rise to the mutual welding thereof. Another possible technique is the eutectic bonding, wherein between the two supports is interposed a layer of a metal or alloy capable of forming an eutectic composition with the material of at least one of the two supports, so that with a suitable thermal treatment a localized melting in the welding area is caused. Finally, it would be possible to use the direct bonding, which comprises the localized melting of the material of the supports, but this process generally requires too high temperatures, for example of about 1000 °C in the case of silicon, which may damage the component parts of the microdevice. Generally, all the types of bonding require a previous treatment of the surfaces to be fixed to each other, because dirty surfaces endanger the tightness of the welding. These treatments are both of mechanical type (gas blowing or mechanical washing with solid CO₂), aimed to remove particles present in the welding area, and of chemical type, to eliminate the species (for example oxides) which alter the composition of the surface; the chemical treatments generally involve washings of the support with acid or basic solutions, or combinations thereof in sequence.

All MEMS devices require a specific atmosphere for their working: for example, the inner space of microbolometers must rigorously be under vacuum, because traces of gases, if any, would give a convective contribution to the heat transfer in the system which would alter the measurement; the MEMS with moving parts may be in vacuum or in inert atmosphere, but the humidity content of the atmosphere must be controlled because water molecules present on the surface of the different parts which compose the microdevice may give rise to sticking phenomena or modify the friction between the stationary parts and the moving parts, thus modifying the mechanical characteristics of the system. The control of the inner atmosphere of a MEMS is, consequently, extremely important for the proper working thereof.

There are different mechanisms which tend to deteriorate the quality of the inner atmosphere of a MEMS. First, the welding between the two supports, although properly accomplished, always leaves microscopic leaks which are channels for the passage of gases from the outside toward the inside of the cavity wherein the device is housed. Then, the same walls of the cavity and of all the inner parts of the MEMS release during time the gases adsorbed on their surface or dissolved inside the constituent material (phenomenon known as "outgassing"); this problem, common to all the devices under vacuum or containing a controlled atmosphere, is particularly felt in the case of MEMS, since these have a very high value of the ratio between the inner surface and the volume of the cavity. Even though the gas flow toward the inner space of a MEMS due to these two phenomena is small, it is an almost constant flow for the whole life of the device, so that in long periods of time, the total effect of alteration of the atmosphere with respect to the initial one, is important. A third phenomenon which considerably contributes to alter the atmosphere with respect to the optimal one takes place during the manufacturing process of the MEMS. Particularly, the welding of the two supports requires always high temperatures, from some hundreds of degrees up to about 1000 °C; during this manufacturing step, both the components of the MEMS and the material added for the welding, release big amounts of gases which are mostly entrapped in the inner space of the device.

To obviate these problems, MEMS manufacturers use getter materials in the device. However, differently from the traditional productions, wherein the different parts of a device are separately manufactured and finally assembled, in the miniaturized productions, all components of a device are generally manufactured in series on a single support, or at most on two supports. This causes the general problem of the compatibility of each material deposited on a support with any subsequent manufacturing steps; when there is an incompatibility between a material and a process step, the material already deposited must be temporarily protected, for example with polymeric materials which are removed after the critical operation has been performed, but this obviously implies a slowing down and a complication of the process, with consequent increases of costs. The existence of the problem in the MEMS manufacture is acknowledged for example in patent US 6,252,229. In the case of getters, it is known that these materials have a high chemical reactivity with small molecules, apart from noble gases and in some cases nitrogen, and in the prior art it has been thought that the getter, once deposited on a support, has to be protected until the end of the manufacturing process, that is until it has to be exposed to the inner atmosphere of the cavity, already sealed, of the MEMS. In particular, at the state of the art, the treatment of a support whereon a getter material is already present with the acid or basic baths used for pre-treating the surfaces of the two supports before the welding operations, is considered particularly problematic.

This problem is the subject of patent application US-A1-2003/0138656, which discloses a method for manufacturing a support with a getter deposit, particularly for the use in MEMS. This document expressly acknowledges that the getter is a delicate component of the system, and must be temporarily protected from the moment it is manufactured until the end of the manufacturing cycle of the MEMS. For this purpose the above mentioned application suggests to cover the getter deposit with a layer of a few nanometers of a noble metal, for example gold; this layer is inert and resistant to gases and to chemical reagents used in the different manufacturing steps of the MEMS, and thus it protects the getter deposit during said steps. In the last step, the bonding one, the temperature of the process causes the layer of noble metal to diffuse into the underlying material, that is thus exposed to the atmosphere in the cavity of the MEMS.

Other patents disclose methods for avoiding the problem, or mention the necessity of the presence of the getter in the MEMS without disclosing how to integrate the formation of this component in the overall manufacturing process of the final device.

The above mentioned patent US 6,252,229 proposes a manufacturing process which comprises a double step bonding, a "pressure bonding" step along a continue closed line around the cavity to obtain the gastightness, and a second one, for example of anodic bonding, more external with respect to the first one, which aims to accomplish a mechanically resistant welding of the two supports. According to what is disclosed in this document, with this process it would be possible to eliminate the getter in the cavity of the MEMS, but in this way the problem due to the accumulation of gas in the cavity due to the outgassing of the inner surfaces is not solved; furthermore, the method is, in any case, complex and expensive, requiring two process steps for the bonding, which is normally accomplished with a single operation.

Patents US 6,621,134 and US 6,635,509 disclose processes wherein the MEMS is manufactured starting from a single support, thus avoiding the problem of the bonding with the second support. These patents indicate the presence of the getter material; however, since the step of formation of the getter deposit takes place almost at the end of the process, said deposit is produced externally to the cavity, covering small openings obtained on the wall thereof: in these conditions the surface of getter material exposed to gases present in the cavity is extremely limited, whereby the gas sorbing efficacy of the getter during the life of the MEMS is also reduced.

The patent US 5,701,008 discloses a microbolometer manufactured by assembling two supports and containing a getter material. As to the manufacturing process, this document refers to the previous patent US 5,433,639, which relates to a process for manufacturing an infrared radiation sensor of traditional type (not a MEMS), and wherein the different components are manufactured in parallel and finally assembled; the process of US 5,433,639 is not directly applicable to US 5,701,008, at least for what concerns the integration of the getter in the cavity, and therefore this last document does not give any information useful to solve the problem.

Finally, patent US 6,590,850 mentions the general use of a getter in a MEMS and discloses the location thereof, but it does not disclose the manufacturing process of the device and consequently does not mention how to introduce the getter therein; patent US 5,952,572 is even more vague, mentioning only the use of a getter, a combination between titanium and an alloy Zr-V-Fe, without disclosing either the location of the getter in the cavity, and the less the step of introducing the getter in said cavity.

It is therefore clear that according to the present state of the art, the integration of the formation of a deposit of getter material in the manufacturing process of a MEMS is still an open problem, and that the solutions proposed up to now are complicated and expensive.

The object of the present invention is to provide a process free from the problems of the prior art for manufacturing devices which require for their operation a non evaporable getter material.

Said object is achieved according to the present invention with a process wherein:
- a deposit of non evaporable getter material is formed on a support;
- the support with the deposit of non evaporable getter material is then treated with at least an acid or basic solution; and
- the so treated support is then introduced in the inner space of a device whose operation requires the presence of a non evaporable getter material, or is used to form at least a portion of the surface which defines the inner space of said device, in such a way that said deposit is in contact with said space.

The invention is based on the inventors' acknowledgement that the chemical treatments with acid or basic solutions (or combination in sequence thereof), contrary to what is commonly believed by those skilled in the art of getter materials, do not decrease the gas sorbing properties of the material; nor cause the loss of particles from the deposit or its detaching from the support, so that a NEG material may be subjected to chemical treatments used for the manufacturing of some devices wherein said material is required without having recourse to the measures of the prior art. Particularly, the inventors have determined that the chemical treatments with said solutions not only do not cause the loss of particles from the NEG material and do not cause its detachment from the support, but in some cases allow also to improve the gas sorbing properties of the material.

The invention will be in the following described in detail with reference to the attached drawings, wherein:
- Figure 1 shows a part of a support on which a plurality of deposits of NEG material are present, which may be used to manufacture a plurality of devices containing said material;
- Figures 2 and 3 show in cross-section and in an extremely schematic way two possible embodiments of devices containing a NEG material;
- Figures 4 and 5 show graphs representative of gas sorbing characteristics of NEG deposits subjected to the process of the invention.

The invention may be used in all the cases in which the manufacturing process of the device containing the NEG material comprises the treatment of the part onto which said material is deposited with acid or basic solutions. Moreover, the process of the invention may be used for the activation, at least partial, of the NEG material; the activation obtained through chemical way according to the present process may be then optionally followed by a further treatment of thermal activation.

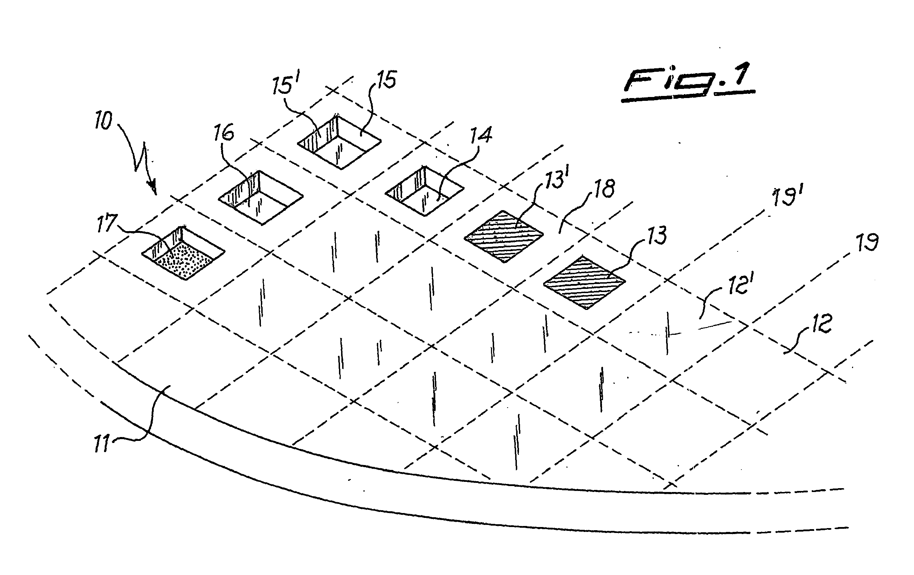

As stated before, the invention is particularly suitable to be used in the manufacturing processes of devices of the MEMS type wherein it is accomplished the bonding of at least two supports, on one of which the getter is present. The supports used in these processes are slices of silicon, glass, quartz or ceramic, called "wafer" in the field, which have generally a thickness of about 0,2-2 millimeters and diameters comprised between about 10 and 30 centimeters. On these wafer there are produced, with different techniques, the active parts of the MEMS device and the NEG deposits. From each wafer are generally obtained from some hundreds to some thousands devices. The NEG material may be deposited on the same support on which is constructed (or from which is obtained) the active part of the device, that may be a moving part or a sensor of electromagnetic radiation. However, the NEG material is preferably deposited onto the other support, the one used to close the device (defined in the field "cap wafer"), because on this part there is more available space and thus it is possible to deposit a greater amount of getter, and because in this way there are no incompatibility problems between the deposition of the getter and the presence of the active structure. Figure 1 shows a part of a "cap wafer" onto which a plurality of NEG deposits are present: for the sake of ease, this cap wafer is represented with some different areas thereof at different working steps, but obviously in the real processes all the parts of its surface will be always in the same manufacturing step. Wafer 10 has a upper surface, 11, ideally divided into areas 12, 12', ... (defined in the figure by the broken lines), each of which will be used to form the closing element of a single MEMS; at the centre of-each area 12, 12', ..., in an area 13, 13', ..., there is obtained, for example through anisotropic chemical attacks known in the semiconductors field, a hollow 14, defined by lateral walls 15, 15', ..., and by a bottom wall 16. On at least one of the walls 15, 15' or 16 the getter deposit 17 is produced; preferably, said device is formed at least on the bottom wall 16, which is the one that offers the greatest surface; furthermore, the most common technique of getter deposition in the MEMS manufacture is sputtering, and wall 16 is the most convenient for said deposition being perpendicular to the arrival direction of the material according to this technique. The finished cap wafer 10, wherein all the hollows 14 have internally a deposit 17 of getter material, is then placed over the support (not shown) on which the active components of the MEMS are constructed, in such a way that the hollows 14 define the cavity of the finished MEMS device, and that the walls 15, 15',... and 16 form, together with the surface of the other support, the walls of said cavity. The welding between the cap wafer 10 and the support on which the active components of the MEMS are present is carried out in the areas 18, that is the peripheric areas of each area 12, 12',...; the welding may be carried out by any known method, for example by anodic or eutectic bonding.

The getter material used may be any known NEG material, for example a metal such as zirconium, titanium, tantalum, niobium, hafnium or yttrium, or alloys of at least one of these metals (preferably zirconium or titanium) with one or more elements selected among the transition metals, Rare Earths and aluminum.

As previously said, before bonding, areas 18 must be subjected to chemical treatments for their cleaning. In the semiconductor industry there are provided numerous washing baths of the wafers, whose composition is standardized and optimized to obtain specific effects; these baths comprise both acid and basic solutions. Typical washing solutions are for example those named SC1 and SC2, wherein the wafer is immersed in sequence; the solution named SC1 is formed of one part (by volume) of ammonium hydroxide, one part of oxygenated water and five parts of distilled water, and is usually used at temperatures comprised between about 60 and 80 °C; the solution named SC2 is formed of one part of hydrochloric acid, one part of oxygenated water and six parts of distilled water, and also in this case it is used at temperatures of about 60-80 °C; after the washing with the solution SC2, and optionally also between the washing SC1 and SC2, the support is generally rinsed with distilled water. Solution SC1 accomplishes a gentle chemical attack of the surface of the wafer, removing organic contaminants and particles which adheres to said surface, while solution SC2 removes the metallic contaminants. Another standard solution used in the field is a solution at 65% by weight of nitric acid in water, which is used at temperatures comprised between room temperature and about 120 °C, and also in this case is followed by rinsing with distilled water. Other standard washings are with aqueous solutions of hydrofluoric or sulphuric acid at different concentrations; a broad description of the different washing solutions used in the field, and of their effects on substrates, is given in the book "Handbook of Semiconductor Manufacturing Technology", edited by Y. Nishi and R. Doering, published in 2000 by Marcel Dekker, Inc. publisher (in particular, see pags. 87-104).

According to the process of the invention, during these steps of chemical attack the whole surface 11 of the cap wafer, as well as the walls of the hollows 14 free of the getter and the getter itself, are subjected to the same treatment, without the necessity of maskings for the temporary protection of the getter; this allows to have a simple, efficient and economic manufacturing process. Once the bonding has been carried out between the cap wafer 10 and the support on which the active components of the MEMS device are constructed, the single devices may be separated by cutting along the broken lines 19, 19', ..., in figure 1.

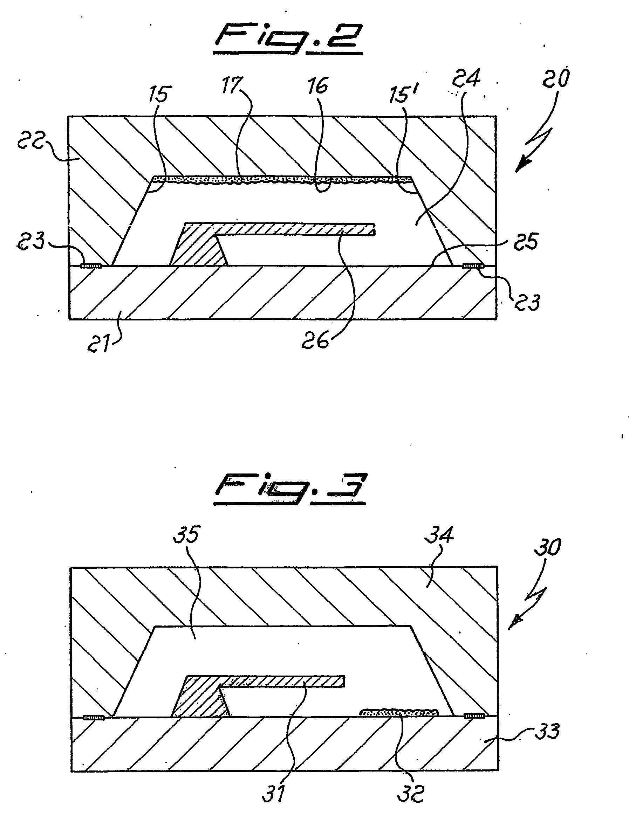

Figure 2 shows in section and in an extremely schematic way a MEMS device which may be manufactured through the process of the invention. The device 20 is formed by assembling a part 21 and a part 22, joined to each other through a welding 23; each of these two parts originates from a support of bigger dimension, and in particular part 22 originates from a support of type 10 after it has been cut along the broken lines of figure 1; said cutting is preferably carried out after the welding operation of the two supports. Between the parts 21 and 22 there is a cavity 24, which may be under vacuum or contain a controlled atmosphere; this cavity is defined by surface 25 of part 21, and by walls 15, 15', ... and 16 described with reference to figure 1. Onto wall 16 of part 22 there is the deposit of getter material 17; finally, in cavity 24 the active part, 26, of the MEMS device is housed. For the sake of simplicity there are not shown other elements which form the device, such as the electrical feedthroughs which connect part 26 with the outside of the device.

Figure 3 shows another possible MEMS device, 30, produced with the process of the invention. In this case, both the active part 31 and the getter deposit 32 are formed on the same part of support 33, while part 34 acts, in this case, simply as closing element of cavity 35; this structure is, however, less preferable than that of figure 2, since, as already said, in this case the space available for the getter deposit 32 is smaller (with a consequent reduced gas sorbing capacity) and the production of both deposit 32 and part 31 on a part 33 of the same support is more complex.

The formation of the getter deposit (17, 32) onto one of the two supports may be carried out according to different techniques, for example by evaporation; the preferred technique is in any case sputtering, which is the technique most widely used in the industrial manufacture of miniaturized devices on planar supports, and thus also of MEMS. The sputtering technique allows to obtain deposits with a thickness from fractions of micrometers (micron, µm) up to some tens of micron, which have an excellent adhesion to the substrate without loss of particles. With this technique it is also possible to control (at least within certain limits) the morphology of the deposit, optimizing it for the expected application; in the case of getter deposits, for example, it is preferable to have a columnar morphology, which shows a high specific surface (surface per unit of weight of the deposit). Moreover, with this technique it is possible to control to a high degree of precision also the lateral location of the deposit, ensuring that all deposits 17 or 32 are always in the same position in each device of type 20 or 30.

The getter deposit 17 or 32, even if it has already been activated during the treatment with the cleaning chemical solutions of the surfaces of the two supports, undergoes a further activation during the bonding of said supports. As already said, all bonding operations imply the heating of the two supports at temperatures of some hundreds of degrees Celsius; at these temperatures all the components of the MEMS devices under manufacture release gases; the bonding operation is usually carried out under pumping, just to eliminate these gases, but during bonding the two supports are necessarily very close, and in the final step of the bonding the cavity of the device is closed and thus the pumping from outside is ineffective. Having an active getter device in this step helps to get rid of the undesirable gases, potentially harmful for the application. The process of the invention, allowing to have an active getter from the very beginning of this operation, ensures a better cleaning of the inner atmosphere of the device, because it increases the period of time in which the getter can play its action.

The invention will be further illustrated by the following examples.

### EXAMPLE 1

In this example it is checked the compatibility of a support with a deposit of getter material with the combined treatment with SC1 and SC2 solutions.

On three silicon disks of 2.5 cm of diameter a 2 µm thick deposit of an alloy made up of zirconium, cobalt and Rare Earths is produced by sputtering; the deposit is produced starting from a target of alloy St 787, disclosed in the patent US 5,961,750 in the name of the applicant. The first sample thus produced is not treated further, and constitutes the reference sample for this test. The second sample is immersed for 15 minutes in a bath of SC1 solution kept at 80 °C, then taken out, rinsed with distilled water and dried with a flow of dry nitrogen. The third sample is first immersed in the SC1 solution and then in the SC2 solution, for a period of 15 minutes for each bath, then rinsed with distilled water and then dried with dry nitrogen.

The three samples so obtained are initially subjected to a visual analysis at the optic microscope to check the morphology of the deposit and the possible detachment from the support; this first examination confirms that after the baths SC1 and SC2 there is no detachment of the deposit from the support, and that the samples treated with said baths do not lose particles.

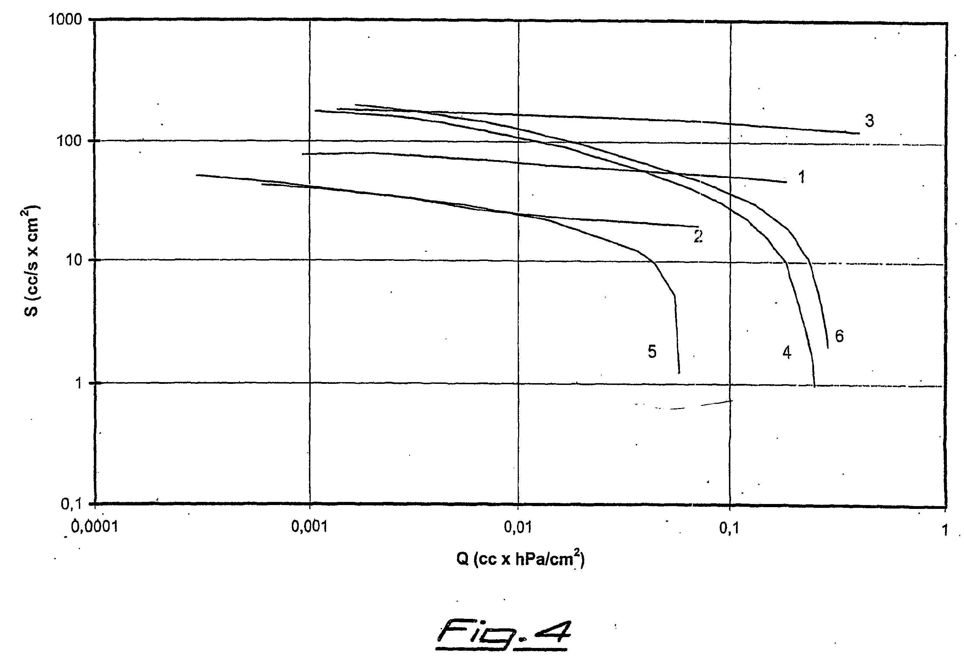

Subsequently, the three samples are assembled in vacuum benches and activated with a treatment under vacuum at 450 °C for 45 minutes; afterwards the samples are allowed to cool at 25 °C and their characteristics of hydrogen and carbon monoxide (CO) sorption are measured, according to the procedure defined in the standard ASTM F 798-82, with a testing pressure of 10⁻⁴ Pa. The results of the six tests are reported in figure 4 (in double logarithmic scale), as gas sorbing rate, S (measured in cc of gas sorbed per second and per square centimeter of deposit) as a function of the amount of gas sorbed, Q (measured in cc of gas sorbed multiplied by the pressure of measure in hectoPascal, hPa, per square centimeter of deposit); in particular, the graphs 1, 2 and 3 in figure 4 are referred to hydrogen sorption respectively on the reference sample, after the single treatment with SC1 and after the treatment with SC2, while the graphs 4-6 are referred to CO sorption on the reference sample, after the treatment with SC1 and after the treatment with SC2.

### EXAMPLE 2

In this example it is checked the compatibility of a deposit of getter material on a support with the combined treatment with aqueous solutions of nitric acid at different temperatures for different period of times.

Four samples similar to those produced for example 1 are prepared. The first one of these in not subjected to any treatment and constitutes the reference sample; the second one is immersed for 30 minutes in an aqueous solution of HNO₃ at 65% by weight at room temperature; the third one is immersed in the same solution for 10 minutes at 60°C; and the fourth one is immersed in the same solution for 10 minutes at 120°C.

Also in this case the four samples, after possible rinsing and drying with nitrogen, are analyzed from the point of view of the detachment from support and of the loss of particles, confirming that the treatments in nitric acid do not alter these two parameters with respect to the reference sample.

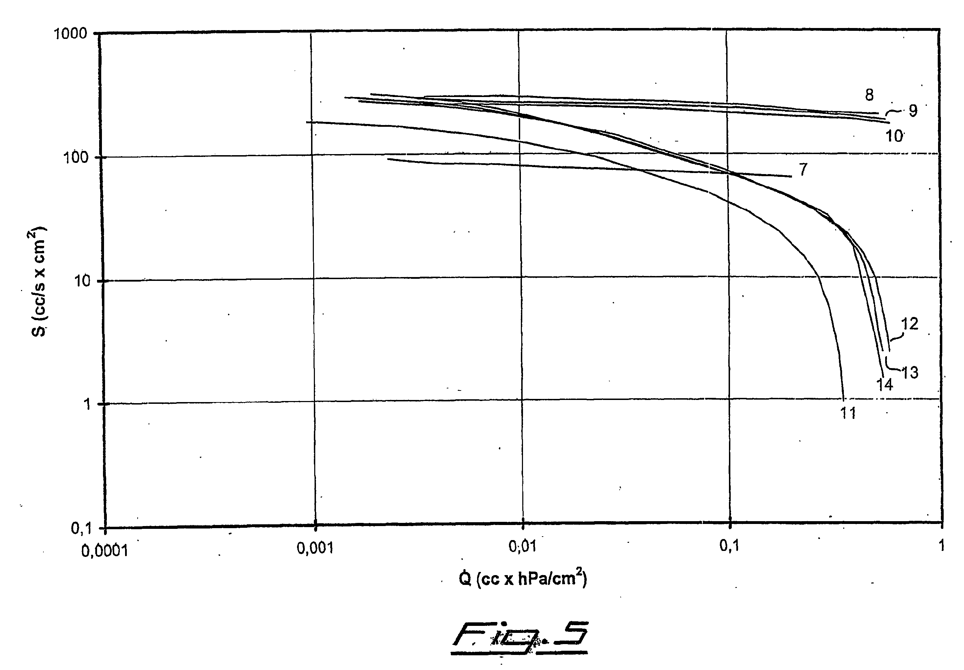

The four samples are then subjected to hydrogen and carbon monoxide sorbing tests as described in example 1. The results of the tests are reported in figure 5, as graphs from 7 to 10 for hydrogen sorption by, respectively, the samples from the first one to the fourth one as described; and graphs from 11 to 14 refer to CO sorption by the four samples (graphs 7 and 11 thus represent the properties of the reference samples in hydrogen and CO sorption, respectively).

As can be noted from the graphs reported in figure 4, while the SC1 treatment worsens the sorbing characteristics of the getter films both for hydrogen and CO, the subsequent treatment with SC2 implies an improvement, increasing the hydrogen sorption to a value that is about three times that of the reference sample, and increasing rate and capacity of CO sorption of about one order of magnitude. All the three treatments tested with nitric acid, instead, give rise to sorbing characteristics of both hydrogen and CO comparable one to the other, and also in this case sensibly better than those of the reference sample.

## Claims

1. A process for manufacturing a device which requires for its working a non evaporable getter material, comprising the following steps:
- a deposit of a non evaporable getter material (17; 32) is formed on a support (10);
- the support with the deposit of non evaporable getter material is then treated with at least an acid or basic solution; and
- the so treated support is then introduced in the inner space of a device whose operation requires the presence of a non evaporable getter material, or is used to form at least a portion of the surface which defines the inner space of said device (20; 30), in such a way that said deposit is in contact with said space.

2. A process according to claim 1 wherein said solution contains ammonia.

3. A process according to claim 1 wherein said solution contains an acid selected among hydrochloric acid, hydrofluoric acid, nitric acid and sulphuric acid.

4. A process according to claim 1 wherein the treatment with acid or basic solution comprises a first treatment in a basic solution of ammonia and a second treatment in an acid solution of hydrochloric acid.

5. A process according to claim 1 wherein said device is a miniaturized mechanical, electromechanical or optical device.

6. A process according to claim 5 wherein said support is the closing support (22) of a miniaturized mechanical or electromechanical device.

7. A process according to claim 5 wherein said support is the support (33) on which the active component of a miniaturized mechanical, electromechanical or optical device is constructed.

8. A process according to claim 1 wherein said non evaporable getter material is selected among zirconium, titanium, tantalum, niobium, hafnium and yttrium, or alloys of at least one of these metals with one or more elements selected among the transition metals, Rare Earths and aluminum.

9. A process according to claim 1 wherein said getter deposit is formed by sputtering.

## Patentansprüche

1. Verfahren zur Herstellung einer Vorrichtung, welche für ihr Funktionieren ein nicht verdampfbares Gettermaterial erfordert, die folgenden Schritte umfassend:
- ein Überzug aus einem nicht verdampfbaren Gettermaterial (17; 32) wird auf einem Träger (10) ausgebildet;
- der Träger mit dem Überzug aus nicht verdampfbarem Gettermaterial wird danach mit mindestens einer sauren oder basischen Lösung behandelt; und
- der so behandelte Träger wird anschließend in den Innenraum einer Vorrichtung eingeführt, deren Betrieb das Vorhandensein eines nicht verdampfbaren Gettermaterials erfordert, oder wird verwendet, um mindestens einen Teil der Fläche auszubilden, welche den Innenraum der Vorrichtung (20; 30) definiert, auf eine solche Weise, dass sich der Überzug in Kontakt mit dem Raum befindet.

2. Verfahren nach Anspruch 1, wobei die Lösung Ammoniak enthält.

3. Verfahren nach Anspruch 1, wobei die Lösung eine Säure enthält, die ausgewählt ist unter Salzsäure, Flusssäure, Salpetersäure und Schwefelsäure.

4. Verfahren nach Anspruch 1, wobei die Behandlung mit saurer oder basischer Lösung eine erste Behandlung in einer basischen Lösung von Ammoniak und eine zweite Behandlung in einer sauren Lösung von Salzsäure umfasst.

5. Verfahren nach Anspruch 1, wobei die Vorrichtung eine miniaturisierte mechanische, elektromechanische oder optische Vorrichtung ist.

6. Verfahren nach Anspruch 5, wobei der Träger der verschließende Träger (22) einer miniaturisierten mechanischen oder elektromechanischen Vorrichtung ist.

7. Verfahren nach Anspruch 5, wobei der Träger der Träger (33) ist, auf welchem die aktive Komponente einer miniaturisierten mechanischen, elektromechanischen oder optischen Vorrichtung ausgebildet ist.

8. Verfahren nach Anspruch 1, wobei das nicht verdampfbare Gettermaterial ausgewählt ist unter Zirkonium, Titan, Tantal, Niob, Hafnium und Yttrium, oder Legierungen von mindestens einem dieser Metalle mit einem oder mehreren Elementen, die ausgewählt sind unter den Übergangsmetallen, Seltenerden und Aluminium.

9. Verfahren nach Anspruch 1, wobei der Getterüberzug durch Sputtern ausgebildet wird.

## Revendications

1. Procédé de fabrication d'un dispositif qui nécessite pour son activité un matériau dégazeur non évaporable, comprenant les étapes dans lesquelles :
- un dépôt d'un matériau dégazeur non évaporable (17 ; 32) est formé sur un support (10) ;
- le support muni du dépôt de matériau dégazeur non évaporable est ensuite traité avec au moins une solution acide ou basique ; et
- le support ainsi traité est ensuite introduit dans l'espace intérieur d'un dispositif dont le fonctionnement nécessite la présence d'un matériau dégazeur non évaporable, ou est utilisé pour former au moins une partie de la surface qui définit l'espace intérieur dudit dispositif (20 ; 30), de manière telle que ledit dépôt soit en contact avec ledit espace.

2. Procédé selon la revendication 1, dans lequel ladite solution contient de l'ammoniac.

3. Procédé selon la revendication 1, dans lequel ladite solution contient un acide sélectionné parmi l'acide chlorhydrique, l'acide fluorhydrique, l'acide nitrique et l'acide sulfurique.

4. Procédé selon la revendication 1, dans lequel le traitement avec une solution acide ou basique comprend un premier traitement dans une solution d'ammoniac basique et un second traitement dans une solution acide d'acide chlorhydrique.

5. Procédé selon la revendication 1, dans lequel ledit dispositif est un dispositif miniaturisé mécanique, électromécanique ou optique.

6. Procédé selon la revendication 5, dans lequel ledit support est le support de fermeture (22) d'un dispositif miniaturisé mécanique ou électromécanique.

7. Procédé selon la revendication 5, dans lequel ledit support est le support (33) sur lequel est construit le composant actif d'un dispositif miniaturisé mécanique, électromécanique ou optique.

8. Procédé selon la revendication 1, dans lequel ledit matériau dégazeur non évaporable est sélectionné parmi le zirconium, le titane, le tantale, le niobium, l'hafnium et l'yttrium, ou des alliages d'au moins un de ces matériaux avec un ou plusieurs éléments sélectionnés parmi les métaux de transition, les terres rares et l'aluminium.

9. Procédé selon la revendication 1, dans lequel ledit dépôt de dégazeur est formé par pulvérisation.
